# EUROPEAN PATENT SPECIFICATION

(11) **EP 3 933 567 B1**
(45) Date of publication and mention of the grant of the patent: **09.10.2024**
(21) Application number: 20926376.3
(22) Date of filing: 20.11.2020
(51) Int. Cl.: G11C 29/44, G06F 3/06, G11C 29/42, G11C 29/52, G11C 29/18, G11C 29/04

(54) **READ-WRITE METHOD AND MEMORY DEVICE**
LESE-SCHREIB-VERFAHREN UND SPEICHERVORRICHTUNG
PROCÉDÉ DE LECTURE-ÉCRITURE ET DISPOSITIF DE MÉMOIRE

(30) Priority: 01.04.2020 CN 202010249668
(43) Date of publication of application: 05.01.2022
(73) Proprietor: Changxin Memory Technologies, Inc., Hefei, Anhui 230000 (CN)
(72) Inventor: NING, Shuliang, Hefei Anhui 230601 (CN)
(74) Representative: Gulde & Partner
(86) International application number: PCT/CN2020/130388
(87) International publication number: WO 2021/196660

(56) References cited:
- CN-A- 103 309 775
- CN-A- 103 778 065
- CN-A- 105 740 163
- CN-A- 107 247 563
- CN-A- 107 247 563
- US-A1- 2007 294 570
- US-A1- 2015 127 972
- US-A1- 2015 143 198
- US-A1- 2017 123 879
- US-A1- 2017 262 178

## Description

### Cross-Reference to Related Applications

The present application claims the priority to Chinese Patent Application No. 202010249668.5, titled "READ-WRITE METHOD AND MEMORY", filed on April 1 , 2020.

### Technical Field

The present invention relates to the field of semiconductor storage, and in particular, to a read-write method and a memory.

### Background

A semiconductor memory is a memory component configured to store various types of data. As the complexity level of the memory circuits increases, poor or damaged storage units are inevitably produced during the production process or use of the memories, resulting in reduced reliability of the semiconductor memories.

D1 (US 2015/0127972 A1) discloses a memory module including a non-volatile cell array and a re-mapper. A page map table is stored in the non-volatile cell array, and includes mappings of old page addresses to new page addresses. The re-mapper is configured to direct memory operations referencing an old page address to the new page address that the old page address is mapped to.

D2 (US 2017/0262178 A1) discloses a storage system that includes a storage device including a controller and a nonvolatile memory unit, and a host including a processor configured to determine whether or not the host is going to access the storage device within a predetermined range of time, and cause the storage device to be powered off when it is determined that the host is not going to access the storage device within the predetermined range of time.

D3 (US 2015/0143198 A1) discloses a system for replacing a page stored in system memory when reading the page incurs a multiple-bit error.

D4 (CN 107247563 A) discloses a block information identification implementing method of an NAND FLASH chip. Based on a computer system with the Nand Flash chip, firstly, a block information identification table of the Nand Flash chip is established in the system and used for storing block information and corresponding index address information; the Nand Flash chip is subjected to write operation, read operation and erasure operation, when the block information is marked as good blocks in the block information identification table, corresponding operation is carried out, and when the block information is marked as bad blocks, skipping is carried out; when failure occurs, corresponding block identification in the block information table is bad block identification; when all the good blocks are used up, a Nand Flash chip overwrite signal is sent to the system.

Therefore, there's an urgent need to avoid the foregoing situation.

### Summary

The objective of the present invention is to provide a read-write method and a memory, to significantly improve the reliability and service life of the memory.

The invention is set out in the appended set of claims.

The present invention has the following advantages: when a user executes a read-write operation on the memory, the address of the storage unit is marked, to distinguish enabled storage units from failed storage units in real time. That is, each time a read operation is executed, an address of a failed storage unit is marked, so that when the user executes a read operation or a write operation on the memory, the user may execute the read-write operation only on an enabled storage unit instead of a failed storage unit. This avoids a data error or a data loss, thereby greatly improving the reliability and the service life of the memory.

### Brief Description of the Drawings

FIG. 1 is a schematic flowchart of a first specific embodiment of a read-write method of the present invention.
FIG. 2 is a schematic flowchart of a second specific embodiment of a read-write method of the present invention.
FIG. 3 is a schematic flowchart of a third specific embodiment of a read-write method of the present invention.
FIG. 4 is a schematic framework diagram of a first specific embodiment of a memory of the present invention.
FIG. 5 is a schematic framework diagram of a second specific embodiment of a memory of the present invention.
FIG. 6 is a schematic framework diagram of a third specific embodiment of a memory of the present invention.
FIG. 7 is a schematic framework diagram of a fourth specific embodiment of a memory of the present invention.
FIG. 8 is a schematic framework diagram of a fifth specific embodiment of a memory of the present invention.

### Detailed Description

The specific embodiments of a read-write method and a memory provided by the present invention are described in detail below in combination with the accompanying drawings.

A common method for improving the reliability of a memory is to encode data into an Error Correction Code (ECC) before writing the data into the memory, and store both the data and the ECC in the memory. In a read operation, both the data and the ECC are read, and the ECC is decoded to restore the data in which an error may occur.

However, the inventor found that the ECC can only be used to correct the data when the data is read out, and the erroneous data still remains in the storage unit of the memory. In a subsequent data storage process, if another data error occurs in at least one storage unit in the storage segment corresponding to the storage unit with the data error, then the storage segment will have at least two storage units with erroneous data. The ECC cannot be used to correct the erroneous data in such situation. As a result, the storage segment may become disabled, sometimes so does the whole memory, thus affecting the reliability and the service life of the memory.

Through research, the inventor found that if a storage unit with a data error can be marked in real time during the use of a memory, it will provide a basis for a subsequent read-write operation, thereby greatly improving the reliability of the memory. Therefore, a read-write method is provided in the present invention, which may mark a storage unit with a data error in real time.

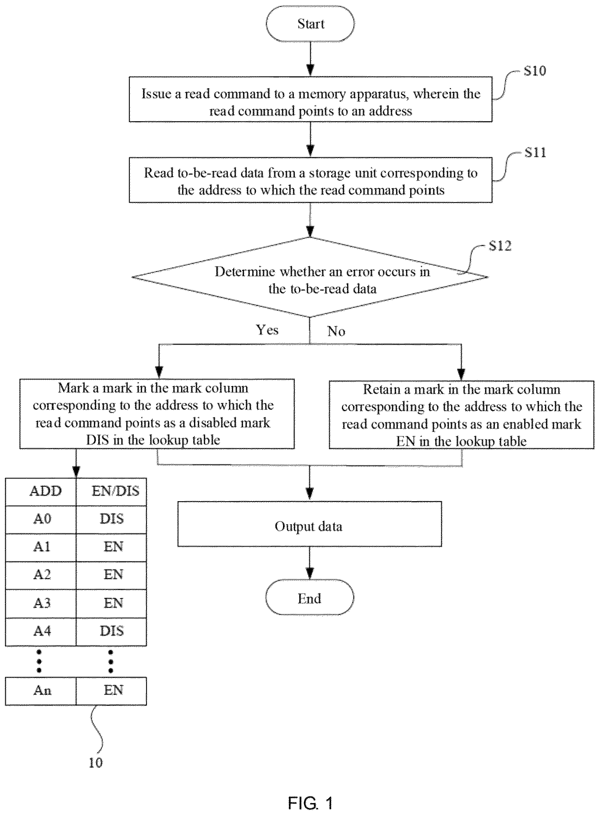

In the first specific embodiment of the read-write method of the present invention, when executing a read operation, the address corresponding to the storage unit in which an error occurs in the to-be-read data is marked. Specifically, please refer to FIG. 1, which is a schematic flowchart of a first specific embodiment of a read-write method of the present invention, and the read-write method includes the following steps:
Step S10, a read command is issued to a memory, the read command points to an address. For example, the address to which the read command points is A0.
Step S11, to-be-read data is read from the storage unit corresponding to the address to which the read command points. For example, the to-be-read data is read from the storage unit corresponding to the address A0.
Step S12, it is determined whether an error occurs in the to-be-read data.

If an error occurs in the to-be-read data, it indicates that the storage unit fails, the address to which the read command points is marked as disabled.

In this specific embodiment, a lookup table 10 is provided, and an address column ADD and a mark column EN/DIS are set in the lookup table 10. The address column ADD pre-stores all the addresses of the memory, for example, A0, A1, A2, A3, A4, A5, A6, ...An, the number of addresses may be set based on actual needs of the memory. The mark column EN/DIS is used to store the marks of the addresses. The marks include disabled marks DIS identifying that the addresses are disabled, or enabled marks EN identifying that the addresses are enabled. The disabled mark DIS and the enabled mark EN may be represented by a binary code (for example, if the binary code has 1 bit, 1 represents the enabled mark EN, while 0 represents the disabled mark DIS), it is not limited in the present invention. Wherein, each address corresponds to one mark.

Specifically, if an error occurs in the to-be-read data read from the storage unit corresponding to the address A0 to which the read command points, the mark in the mark column corresponding to the address A0 to which the read command points is marked as the disabled mark DIS in the lookup table 10; if an error occurs in the to-be-read data read from the storage unit corresponding to the address A4 to which the read command points, the mark in the mark column corresponding to the address A4 to which the read command points is marked as the disabled mark DIS in the lookup table 10.

If no error occurs in the to-be-read data, it indicates that the storage unit is enabled, the following two processing modes may be adopted:
In the first processing mode, if no error occurs in the to-be-read data, the address to which the read command points is marked as an enabled mark EN in the lookup table 10. For example, if no error occurs in the to-be-read data read from the storage unit corresponding to the address A1 to which the read command points, the mark in the mark column corresponding to the address A1 to which the read command points is marked as the enabled mark EN in the lookup table 10.

In the second processing mode, the marks in the mark column corresponding to all the addresses are initially set as enabled marks EN in the lookup table 10. In this case, if no error occurs in the to-be-read data, the mark in the mark column in the lookup table is not modified, that is, the initial setting of the mark column is retained. For example, if no error occurs in to-be-read data read from the storage unit corresponding to the address A1 to which the read command points, the mark in the mark column corresponding to the address A1 to which the read command points is retained as the enabled mark EN in the lookup table, that is, the initial setting of the mark column is not modified. The second processing mode is adopted in this specific embodiment.

In the second processing mode, only when an error occurs in the to-be-read data read from the storage unit corresponding to the address to which the read command points, the enabled mark EN in the mark column corresponding to the address to which the read command points is modified to a disabled mark DIS in the lookup table 10. For example, if an error occurs in the to-be-read data read from the storage unit corresponding to the address A0 to which the read command points, the enabled mark EN in the mark column corresponding to the address A0 to which the read command points is modified to a disabled mark DIS in the lookup table 10.

Further, in the second processing mode, when the memory is powered on or leaves the factory, the marks in the mark column corresponding to all the addresses are initially set to enabled marks EN in the lookup table 10. It should be understood that, during the use of the memory and after executing the read-write operation on the memory for multiple times, the mark in the mark column corresponding to the address may be marked as a disabled mark DIS or an enabled mark EN in the lookup table 10. Therefore, when issuing the read command to the memory, the lookup table obtained after executing the previous read-write operation serves as the initial lookup table for the current read operation. The initial lookup table records the marks of the addresses of the storage unit after the previous read-write operation, the marks serve as the initial marks of the current read operation which may be disabled marks DIS or enabled marks EN. If an error occurs in the to-be-read data, the initial mark of the address to which the read command points is modified to a disabled mark DIS in the lookup table.

Further, a method for determining whether an error occurs in the to-be-read data is further provided in the present invention. Specifically, the reading to-be-read data from a storage unit corresponding to the address to which the read command points further includes: reading a first ECC associated with the to-be-read data from the storage unit corresponding to the address to which the read command points. For example, the bit quantity of data read from the storage unit corresponding to the address to which the read command points is 64b+8b, wherein 64b is the bit quantity of the to-be-read data, and 8b is the bit quantity of the first ECC. The first ECC is decoded according to relevant algorithms, which can restore the data in which an error may occur. The algorithms are the prior art and will not be repeated. By decoding the first ECC, it may be determined whether an error occurs in the to-be-read data.

A method for determining whether an error occurs in the to-be-read data by decoding the first ECC is further provided in the present invention. The method includes: re-encoding the to-be-read data to generate a new ECC; executing bit wise exclusive-OR comparison between the new ECC and the first ECC; and if bit wise consistency is obtained, it indicates that no error occurs in the to-be-read data and the storage unit is enabled, skip the modification on the lookup table 10, wherein the mark of the address corresponding to the storage unit is an enabled mark EN; if the new ECC is inconsistent with the first ECC, it indicates that an error occurs in the to-be-read data and the storage unit is disabled, mark the address to which the read command points as a disabled mark DIS in the lookup table 10.

If no error occurs in the to-be-read data, the to-be-read data serves as the output data of the memory; and if an error occurs in the to-be-read data, the to-be-read data may be restored by using the first ECC, and the restored data serves as the output data of the memory.

The read-write method provided in the present invention allows marking the address of the storage unit when executing a read-write operation on the memory, to distinguish the enabled storage units from the failed storage units in real time. That is, when executing a read operation on the memory for each time, the address of the failed storage unit will be marked, so that a read-write operation may be executed only on the enabled storage units instead of the failed storage units. A data error or a data loss may be avoided, thereby greatly improving the reliability of the memory.

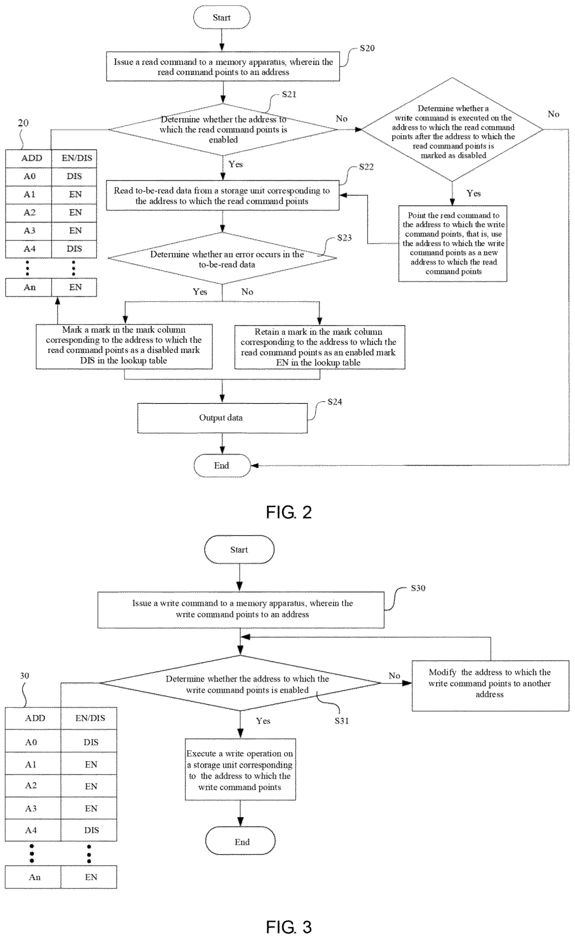

The present invention further provides a second specific embodiment of a read-write method. After issuing the read command to the memory and before reading the to-be-read data from the storage unit corresponding to the address to which the read command points, the second specific embodiment further includes: a step of determining whether the address to which the read command points is enabled. Specifically, please refer to FIG. 2, which is a schematic flowchart of a second specific embodiment of the read-write method of the present invention. Step S20, a read command is issued to a memory. The read command points to an address.

Step S21, it is determined whether the address to which the read command points is enabled.

Specifically, when issuing the read command to the memory, the address to which the read command points is used as an index to search for the mark in the lookup table. In the lookup table, if the mark in the mark column corresponding to the address to which the read command points is an enabled mark EN, it indicates that the address to which the read command points is enabled; if the mark in the mark column corresponding to the address to which the read command points is a disabled mark DIS, it indicates that the address to which the read command points is disabled.

For example, if the address to which the read command points is A1, the address A1 to which the read command points is used as an index to search for the mark in the lookup table 20. In the lookup table 20, if the mark in the mark column corresponding to the address A1 to which the read command points is an enabled mark EN, it indicates that the address A1 to which the read command points is enabled.

For another example, if the address to which the read command points is A4, the address A4 to which the read command points is used as an index to search for the mark in the lookup table 20. In the lookup table 20, if the mark in the mark column corresponding to the address A4 to which the read command points is a disabled mark DIS, it indicates that the address A4 to which the read command points is disabled.

If the address to which the read command points is enabled, a read operation is executed on the storage unit corresponding to the address to which the read command points, that is, step S22 is executed. For example, in the lookup table 20, if the mark in the mark column corresponding to the address A1 to which the read command points is an enabled mark EN, it indicates that the storage unit corresponding to the address A1 to which the read command points is enabled. In this case, a read operation is executed on the storage unit corresponding to the address A1 to which the read command points, that is, step S22 is executed. In step S22, the address to which the read command points is the address A1.

If the address to which the read command points is disabled, that is, in the look up table 20, the mark in the mark column corresponding to the address to which the read command points is a disabled mark DIS, it indicates that the storage unit corresponding to the address to which the read command points is disabled. It is determined whether a write command has been executed on the address to which the read command points after the mark in the mark column corresponding to the address to which the read command points is marked as a disabled mark DIS in the operations before the current read operation. If it is determined that a write command has been executed on the address to which the read command points after the mark in the mark column corresponding to the address to which the read command points is marked as a disabled mark DIS in the operations before the current read operation, the read command is pointed to the address to which the write command points, that is, the address to which the write command points is used as the new address to which the read command points, and step S22 is executed on the new address. If it is determined that no write command has been executed on the address to which the read command points after the mark in the mark column corresponding to the address to which the read command points is marked as a disabled mark DIS in the operations before the current read operation, two processing modes are adopted. One processing mode is to stop the read operation, as shown in FIG. 2 in this specific embodiment. The other processing mode is to continue the read operation and use the data restored by using the first ECC as the output data of the memory.

For example, in the lookup table 20, if the mark in the mark column corresponding to the address A4 to which the read command points is marked as a disabled mark DIS, it is determined whether a write command has been executed on the address A4 to which the read command points after the mark in the mark column corresponding to the address A4 to which the read command points is marked as a disabled mark DIS in the operations before the current read operation. If it is determined that a write command has been executed on the address A4 to which the read command points after the mark in the mark column corresponding to the address A4 to which the read command points is marked as a disabled mark DIS in the operations before the current read operation, and the write command points to another address A1, the read command is pointed to the address A1 to which the write command points to execute a read operation on the storage unit corresponding to the address A1, that is, step S22 is executed. In step S22, the address to which the read command points is the address A1. The third specific embodiment of the read-write method is referred to for the implementation of the write command. If it is determined that no write command has been executed on the address A4 to which the read command points after the mark in the mark column corresponding to the address A4 to which the read command points is marked as a disabled mark DIS in the operations before the current read operation, the read operation is stopped.

Step S22, to-be-read data is read from the storage unit corresponding to the address to which the read command points. For example, the to-be-read data is read from the storage unit corresponding to the address A1 to which the read command points. This step is the same as step S11 in the first specific embodiment of the read-write method.

Step S23, it is determined whether an error occurs in the to-be-read data. This step is the same as step S12 in the first specific embodiment of the read-write method. If an error occurs in the to-be-read data, the mark in the mark column corresponding to the address to which the read command points is marked as a disabled mark DIS in the lookup table 20. If no error occurs in the to-be-read data, the mark in the mark column corresponding to the address to which the read command points is marked as an enabled mark EN in the lookup table 20, or the lookup table 20 is not modified when all the marks in the mark column in the lookup table 20 are initially set as enabled marks EN.

Step S24, data is outputted.

In this second specific embodiment, after issuing the read command to the memory, whether the address to which the read command points is enabled is determined to selectively execute the read command on the address to which the read command points, thereby improving the reliability of the memory. Additionally, after reading the to-be-read data, the address of the storage unit may be marked based on whether an error occurs in the to-be-read data, so as to provide a basis of determination for a subsequent read-write operation.

The present invention further provides a third specific embodiment. The third specific embodiment is a write operation on a memory. Specifically, please refer to FIG. 3, which is a schematic flowchart of the third specific embodiment of the read-write method of the present invention. Step S30, a write command is issued to the memory, and the write command points to an address. For example, a write command is issued to the memory, and the write command points to the address A0.

Step S31, it is determined whether the mark of the address to which the write command points is enabled.

In this specific embodiment, the address to which the write command points is used as an index to search for the mark corresponding to the address in the lookup table 30 to determine, based on the mark, whether the address to which the write command points is enabled.

For example, if the address to which the write command points is A0, the address A0 to which the write command points is used as an index to search for the mark in the mark column corresponding to the address A0 in the lookup table 30 to determine, based on the mark, whether the address A0 to which the write command points is enabled. If the address to which the write command points is A1, the address A1 to which the write command points is used as an index to search for the mark in the mark column corresponding to the address A1 in the lookup table 30 to determine, based on the mark, whether the address A1 to which the write command points is enabled.

If the mark of the address to which the write command points is enabled, a write operation is executed on the storage unit corresponding to the address to which the write command points. If the mark of the address to which the write command points is disabled, the write operation on the storage unit corresponding to the address to which the write command points is stopped.

For example, if the mark in the mark column corresponding to the address A0 to which the write command points is a disabled mark DIS in the lookup table 30, the write operation on the storage unit corresponding to the address A0 to which the write command points is stopped. If the mark in the mark column corresponding to the address A1 to which the write command points is an enabled mark EN in the lookup table 30, a write operation is executed on the storage unit corresponding to the address A1 to which the write command points.

Further, in the third specific embodiment, after stopping the write operation on the storage unit corresponding to the address to which the write command points, it further includes: modifying the address to which the write command points to another address. After this step, it is further determined whether another address is enabled. The determining method is the same as step S31. If the mark of another address is an enabled mark, a write operation is executed on the storage unit corresponding to another address. If the mark of another address is a disabled mark, the write operation on the storage unit corresponding to another address is stopped, and the address to which the write command points is further modified to other address.

For example, after stopping the write operation on the storage unit corresponding to the address A0 to which the write command points, the address A0 to which the write command points is modified to the other address A1, that is, the write command points to the address A1. Further, it is determined whether the address A1 to which the write command points is enabled, that is, it is determined whether the mark of the address A1 is enabled. For example, in this specific embodiment, if the mark in the mark column corresponding to the address A1 is an enabled mark EN, a write operation is executed on the storage unit corresponding to the address A1. In some other embodiments, if the address A1 is disabled, the write operation on the storage unit corresponding to the address A1 is stopped, and the address of the write command is modified to A2. Then it is further determined whether the address A2 is enabled. The foregoing operation is repeated until the mark of the address to which the write command points is an enabled mark.

Further, in this third specific embodiment, the read-write method further includes: generating a second ECC associated with to-be-written data in the write operation, and writing the second ECC together with the to-be-written data into the storage unit corresponding to the address to which the write command points. When reading the data in the storage unit, both the data and the second ECC are read, and the second ECC is decoded to restore the data in which an error occurs.

In this third specific embodiment, after issuing the write command to the memory, it is determined whether the address to which the write command points is enabled, so as to serve as a basis for whether to execute a write operation on the storage unit. By doing so, a write operation on a failed storage unit is avoided, thereby improving the reliability of the memory and prolonging the service life of the memory.

A memory that can implement the foregoing read-write method is further provided in the present invention. The memory includes but is not limited to a volatile memory such as DRAM or SRAM, and a non-volatile memory such as NAND, NOR, FeRAM, RRAM, MRAM, or PCRAM.

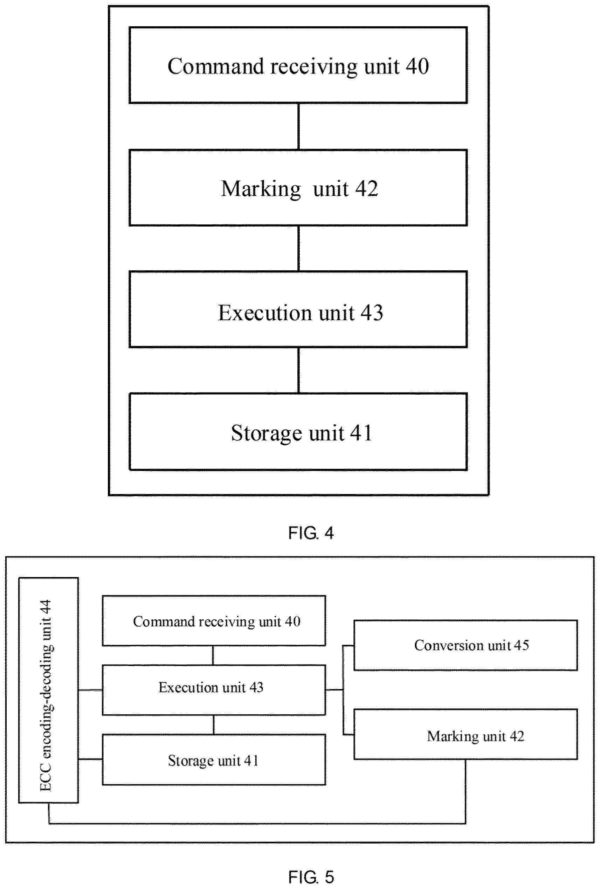

Refer to FIG. 4, which is a schematic framework diagram of the first specific embodiment of the memory of the present invention. The memory includes a command receiving unit 40, a storage unit 41, a marking unit 42, and an execution unit 43.

The command receiving unit 40 is configured to receive address to which a read command, a write command, or a read-write command issued to the memory points.

The storage unit 41 corresponds to the address subject to the read command or the write command, and is configured to store data. In the present invention, the storage unit 41 may be a storage unit familiar to a person skilled in the art, such as a storage cell, a storage segment, a storage page, or a storage block, which is not limited in the present invention.

The marking unit 42 is configured to store marking information. The marking information records whether the address is enabled or disabled. In this specific embodiment, the marking unit 42 is a lookup table, and the lookup table records the address of the storage unit 41 and the initial mark thereof. The initial mark is an enabled mark. If an error occurs in the to-be-read data, the initial mark of the address is modified to be disabled in the lookup table; or if no error occurs in the to-be-read data, the initial mark is retained. In another specific embodiment of the present invention, the mark corresponding to the address is not initially set to enabled in the lookup table, and if an error occurs in the to-be-read data, the address is marked as disabled in the lookup table; or if no error occurs in the to-be-read data, the address is marked as enabled in the lookup table.

The execution unit 43 is configured to control the execution of a read operation or a write operation on the storage unit 41. The execution unit 43 is further connected to the marking unit 42, and is configured to, based on the marking information in the marking unit 42, execute the read operation or the write operation on the storage unit corresponding to the address or stop the read operation or the write operation on the storage unit corresponding to the address. Specifically, if the marking information corresponding to the address to which the read command or the write command points is an enabled mark, the execution unit 43 executes the read operation or the write operation on the storage unit corresponding to the address; or if the marking information corresponding to the address to which the read command or the write command points is a disabled mark, the execution unit 43 stops the read operation or the write operation on the storage unit corresponding to the address.

It should be noted that, in some other specific embodiments, the marking unit 42 is connected only to the execution unit 43, and the command receiving unit 40 is directly connected to the execution unit 43. The connection mode is not limited in the present invention, and a person of ordinary skills in the art may set the connection mode based on actual needs.

The present invention further provides a second specific embodiment of a memory. Refer to FIG. 5, which is a schematic framework diagram of the second specific embodiment of the memory of the present invention. The difference between the second embodiment and the first embodiment of the memory lies in that the memory further includes an ECC encoding-decoding unit 44.

The ECC encoding-decoding unit 44 is connected to the execution unit 43, the storage unit 41, and the marking unit 42.

The ECC encoding-decoding unit 44 is configured to decode the first ECC associated with the to-be-read data in a read operation, to restore data in which an error occurs, and to modify the marking information in the marking unit 42 based on whether the ECC encoding-decoding unit 44 restores the data. The ECC encoding-decoding unit 44 is further configured to generate the second ECC associated with the to-be-written data in a write operation.

Specifically, in this specific embodiment, the command receiving unit receives a write command. When executing a write operation on the storage unit corresponding to the address to which the write command points, the ECC encoding-decoding unit 44 generates an ECC associated with the to-be-written data in the write operation, and store the ECC and the to-be-written data together in the storage unit 41 corresponding to the address to which the write command points. After the write operation is completed, when executing a read operation subsequently on the storage unit corresponding to the address, the ECC encoding-decoding unit 44 decodes the ECC. It is determined, based on the decoding of the ECC encoding-decoding unit 44, whether an error occurs in the to-be-read data read in the read operation. Then the marking information in the marking unit 42 is modified.

Further, in this specific embodiment, the marking information in the marking unit 42 is modified based on whether the ECC encoding-decoding unit 44 restores the data. Specifically, if the ECC encoding-decoding unit 44 decodes the ECC and restores the data, it indicates that an error occurs in the to-be-read data read in the read operation, then the address of the storage unit is marked as a disabled mark in the marking unit 42. If the ECC encoding-decoding unit 44 decodes the ECC but does not restore the data, it indicates that no error occurs in the to-be-read data read in the read operation, then the mark of the address is modified as an enabled mark in the marking unit 42, or an initial mark of the address is retained.

In some other specific embodiments of the present invention, although the ECC encoding-decoding unit 44 does not restore the data after decoding the ECC, it is determined, based on the decoding of the ECC encoding-decoding unit 44, that an error occurs in the to-be-read data read in the read operation. In this case, the address of the storage unit is marked as a disabled mark in the marking unit 42.

Further, in the second specific embodiment of the memory, the memory further includes a conversion unit 45. The conversion unit 45 is connected to the execution unit 43. After stopping the read operation or the write operation on the storage unit corresponding to the address, the conversion unit 45 modifies the address to which the read command or the write command points to another address. The execution unit 43 further executes a read operation or a write operation on another address based on the marking information in the marking unit.

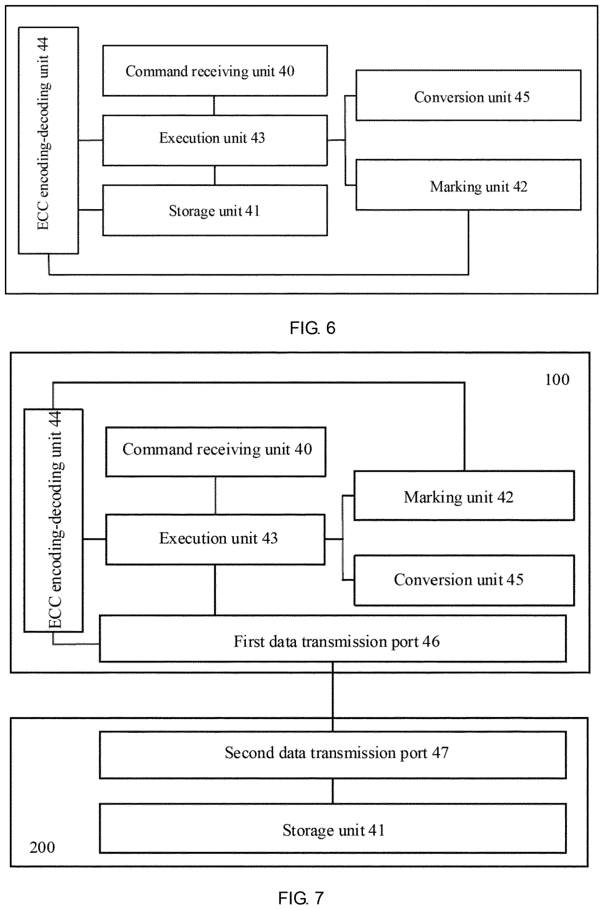

In this second specific embodiment of the memory, the execution unit 43 is not only connected to the ECC encoding-decoding unit 44, but also connected to the storage unit 41. In the third specific embodiment of the present invention, refer to FIG. 6, which is a schematic framework diagram of a third specific embodiment of the memory of the present invention. The execution unit 43 is connected to the ECC encoding-decoding unit 44, and the ECC encoding-decoding unit 44 is further connected to the storage unit 41. It should be understood that the connection mode can be set based on actual needs.

The present invention further provides a fourth specific embodiment of a memory. Refer to FIG. 7, which is a schematic framework diagram of the fourth specific embodiment of the memory of the present invention. In comparison with the second specific embodiment of the memory, the memory includes a logical layer 100 and several storage layers 200 (only one storage layer 200 is shown in FIG. 7). The storage layers 200 may be DRAM chips, and the logical layer 100 may be a layer having a logical circuit, such as a control chip or an intermediate layer. The several storage layers 200 may be vertically stacked above or below the logical layer 100, which is not limited in the present invention, or may be integrated by other packaging methods.

The command receiving unit 40, the marking unit 42, the execution unit 43, the ECC encoding-decoding unit 44, and the conversion unit 45 may all be disposed in the logical layer 100, and the storage unit 41 is disposed in the storage layers 200. In another specific embodiment of the present invention, the marking unit 42 and the ECC encoding-decoding unit 44 may also be disposed in the storage layers 200.

In this specific embodiment, the logical layer 100 has at least one first data transmission port 46, and the storage layers 200 have at least one second data transmission port 47. Instructions and data are transmitted between the logical layer 100 and the storage layers 200 via the first data transmission port 46 and the second data transmission port 47.

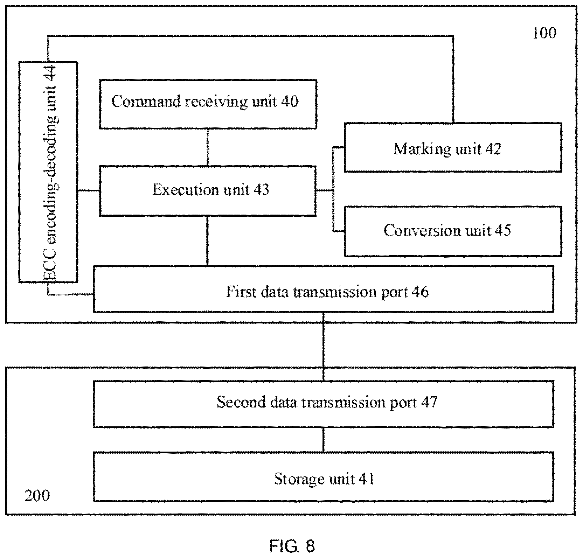

Further, in the fourth specific embodiment, the execution unit 43 is not only connected to the ECC encoding-decoding unit 44, but also connected to the storage unit 41 via the first data transmission port 46 and the second data transmission port 47. In the fifth specific embodiment of the present invention, refer to FIG. 8, which is a schematic framework diagram of the fifth specific embodiment of the memory of the present invention. The execution unit 43 is connected to the ECC encoding-decoding unit 44, and the ECC encoding-decoding unit 44 is further connected to the storage unit 41 via the first data transmission port 46 and the second data transmission port 47. It should be understood that the connection mode can be set based on actual needs. The memory provided in the present invention may mark a failed storage unit during a process of use, to selectively execute a read-write operation on the storage unit, thereby greatly improving the reliability and the service life of the memory.

The foregoing descriptions are merely some preferred embodiments of the present invention. A person of ordinary skills in the art may further make several improvements and modifications within the scope of the invention as defined by the appended claims.

## Claims

1. A read-write method, comprising:
receiving a read command, wherein the read command points to an address (S10, S20);
using the address to which the read command points as an index to search for a mark corresponding to the address to which the read command points in a lookup table (10, 20), wherein the lookup table (10, 20) stores all addresses of a memory and marks corresponding to the addresses, the marks comprise disabled marks or enabled marks, and a mark corresponding to an address not marked as a disabled mark is initially set to be an enable mark; and
in response to the mark corresponding to the address to which the read command points being an enabled mark, reading (S11, S22) to-be-read data from a storage unit corresponding to the address to which the read command points;
and **characterized by** comprising:
in response to the mark corresponding to the address to which the read command points being a disabled mark, determining whether a write command has been executed on the address to which the read command points after the mark corresponding to the address to which the read command points is marked as the disabled mark; and in response to determining that the write command has been executed on the address to which the read command points after the mark corresponding to the address to which the read command points is marked as the disabled mark and the write command has been modified to point to another address, modifying the read command to point to the another address to which the write command points, and reading (S22) to-be-read data from a storage unit corresponding to the another address to which the write command points; and
in response to an error occurring in the to-be-read data, marking the mark corresponding to the address to which the read command points as the disabled mark; in response to no error occurring in the to-be-read data, retaining the mark corresponding to the address to which the read command points, and outputting the to-be-read data (S24);
wherein the reading (S11, S22) to-be-read data from a storage unit corresponding to the address to which the read command points further comprises: reading a first Error Correction Code, ECC, associated with the to-be-read data from the storage unit corresponding to the address to which the read command points;
a method for determining whether the error occurs in the to-be-read data (S12, S23) comprises: decoding the first ECC, to determine whether the error occurs in the to-be-read data; and
the method being applied by the memory.

2. The read-write method according to claim 1, further comprising: receiving a write command (S30); and in response to a mark corresponding to an address to which the write command points being an enabled mark, executing a write operation on a storage unit corresponding to the address to which the write command points; or in response to the mark corresponding to the address to which the write command points being a disabled mark, stopping the write operation on the storage unit corresponding to the address to which the write command points.

3. The read-write method according to claim 2, wherein the receiving a write command (S30) comprises: using the address to which the write command points as an index, to search for the mark corresponding to the address to which the write command points in the lookup table (30).

4. The read-write method according to claim 2, after the stopping the write operation on the storage unit corresponding to the address to which the write command points, the method further comprises:
modifying the address to which the write command points to another address;
after the modifying the address to which the write command points to another address, the method further comprises: determining whether a mark corresponding to the another address is an enabled mark (S31).

5. The read-write method according to claim 2, wherein the executing a write operation on a storage unit corresponding to the address to which the write command points comprises:
generating a second ECC associated with to-be-written data in the write operation, and writing the second ECC together with the to-be-written data into the storage unit corresponding to the address to which the write command points.

6. A memory, comprising:
a command receiving unit (40), configured to receive a read command or a write command;
a storage unit (41), corresponding to an address subject to the read command or the write command;
an execution unit (43), configured to execute a read operation or a write operation on the storage unit (41); and
a marking unit (42), configured to store marking information, wherein the marking information records whether the address is enabled or disabled;
wherein the marking unit (42) is a lookup table, the look up table records the address of the storage unit (41) and an initial mark corresponding to the address, the initial mark corresponding to the address is an enabled mark, and in response to an error occurring in to-be-read data, the initial mark corresponding to the address is modified to be a disabled mark in the lookup table;
and **characterized in that**:
the execution unit (43) is further connected to the marking unit (42), configured to, based on the marking information in the marking unit (42), execute the read operation or the write operation on the storage unit (41) corresponding to the address, or stop the read operation or the write operation on the storage unit (41) corresponding to the address;
the execution unit (43) is configured to: in response to a mark corresponding to the address to which the read command points being the enabled mark, execute the read operation on the storage unit (41) corresponding to the address to which the read command points; in response to the mark corresponding to the address to which the read command points being the disabled mark, determine whether a write command has been executed on the address to which the read command points after the mark corresponding to the address to which the read command points is marked as the disabled mark; and in response to determining that the write command has been executed on the address to which the read command points after the mark corresponding to the address to which the read command points is marked as the disabled mark and the write command has been modified to point to another address, modify the read command to pointed to the another address to which the write command points, and read to-be-read data from a storage unit corresponding to the another address to which the write command points; and
the memory further comprises an ECC encoding-decoding unit (44), configured to decode a first ECC associated with the to-be-read data in the read operation to determine whether the error occurs in the to-be-read data, and generate a second ECC associated with to-be-written data in the write operation.

7. The memory according to claim 6, further comprising: a conversion unit (45), configured to, after stopping the read operation or the write operation on the storage unit (41) corresponding to the address, modify the address to which the read command or the write command points to another address.

8. The memory according to claim 6, comprising: a logical layer (100) and at least one storage layer (200), the command receiving unit (40), the marking unit (42), and the execution unit (43) being disposed in the logical layer (100), and the storage unit (41) being disposed in the storage layer (200).

## Patentansprüche

1. Lese-Schreib-Verfahren, das Folgendes umfasst:
Empfangen eines Lesebefehls, wobei der Lesebefehl auf eine Adresse (S10, S20) zeigt;
Verwenden der Adresse, auf die der Lesebefehl zeigt, als index zum Suchen einer Markierung, die der Adresse entspricht, auf die der Lesebefehl zeigt, in einer Nachschlagetabelle (10, 20), wobei die Nachschlagetabelle (10, 20) alle Adressen eines Speichers und den Adressen entsprechende Markierungen speichert, wobei die Markierungen deaktivierte Markierungen oder aktivierte Markierungen umfassen und eine Markierung, die einer nicht als deaktivierte Markierung markierten Adresse entspricht, anfänglich als aktivierte Markierung eingestellt wird; und
als Reaktion darauf, dass die Markierung, die der Adresse entspricht, auf die der Lesebefehl zeigt, eine aktivierte Markierung ist, Lesen (S11, S22) von zu lesenden Daten aus einer Speichereinheit, die der Adresse entspricht, auf die der Lesebefehl zeigt;
und **dadurch gekennzeichnet, dass** es Folgendes umfasst:
als Reaktion darauf, dass die Markierung, die der Adresse entspricht, auf die der Lesebefehl zeigt, eine deaktivierte Markierung ist, Bestimmen, ob ein Schreibbefehl an der Adresse ausgeführt wurde, auf die der Lesebefehl zeigt, nachdem die Markierung, die der Adresse entspricht, auf die der Lesebefehl zeigt, als deaktivierte Markierung markiert wurde; und als Reaktion auf das Bestimmen, dass der Schreibbefehl an der Adresse ausgeführt wurde, auf die der Lesebefehl zeigt, nachdem die Markierung, die der Adresse entspricht, auf die der Lesebefehl zeigt, als die deaktivierte Markierung markiert wurde, und der Schreibbefehl geändert wurde, um auf eine andere Adresse zu zeigen, Ändern des Lesebefehls, um auf die andere Adresse zu zeigen, auf die der Schreibbefehl zeigt, und Lesen (S22) von zu lesenden Daten aus einer Speichereinheit, die der anderen Adresse entspricht, auf die der Schreibbefehl zeigt; und
als Reaktion darauf, dass ein Fehler in den zu lesenden Daten auftritt, Markieren der Markierung, die der Adresse entspricht, auf die der Lesebefehl zeigt, als die deaktivierte Markierung; als Reaktion darauf, dass kein Fehler in den zu lesenden Daten auftritt, Beibehalten der Markierung, die der Adresse entspricht, auf die der Lesebefehl zeigt, und Ausgeben der zu lesenden Daten (S24);
wobei das Lesen (S11, S22) von zu lesenden Daten aus einer Speichereinheit, die der Adresse entspricht, auf die der Lesebefehl zeigt, ferner umfasst: Lesen eines ersten Fehlerkorrekturcodes, ECC, der den zu lesenden Daten aus der Speichereinheit zugeordnet ist, die der Adresse entspricht, auf die der Lesebefehl zeigt;
wobei ein Verfahren zum Bestimmen, ob der Fehler in den zu lesenden Daten auftritt (S12, S23), umfasst: Dekodieren des ersten ECC, um zu bestimmen, ob der Fehler in den zu lesenden Daten auftritt; und
wobei das Verfahren vom Speicher angewendet wird.

2. Lese-Schreib-Verfahren nach Anspruch 1, ferner umfassend: Empfangen eines Schreibbefehls (S30); und als Reaktion darauf, dass eine Markierung, die einer Adresse entspricht, auf die der Schreibbefehl zeigt, eine aktivierte Markierung ist, Ausführen eines Schreibvorgangs auf einer Speichereinheit, die der Adresse entspricht, auf die der Schreibbefehl zeigt; oder als Reaktion darauf, dass die Markierung, die der Adresse entspricht, auf die der Schreibbefehl zeigt, eine deaktivierte Markierung ist, Stoppen des Schreibvorgangs auf der Speichereinheit, die der Adresse entspricht, auf die der Schreibbefehl zeigt.

3. Lese-Schreib-Verfahren nach Anspruch 2, wobei das Empfangen eines Schreibbefehls (S30) Folgendes umfasst: Verwenden der Adresse, auf die der Schreibbefehl zeigt, als Index, um in der Nachschlagetabelle (30) nach der Markierung zu suchen, die der Adresse entspricht, auf die der Schreibbefehl zeigt.

4. Lese-Schreib-Verfahren nach Anspruch 2, wobei das Verfahren nach dem Stoppen des Schreibvorgangs auf der Speichereinheit, die der Adresse entspricht, auf die der Schreibbefehl zeigt, ferner umfasst:
Ändern der Adresse, auf die der Schreibbefehl zeigt, auf eine andere Adresse;
wobei nach dem Ändern der Adresse, auf die der Schreibbefehl zeigt, auf eine andere Adresse, das Verfahren ferner umfasst: Bestimmen, ob eine Markierung, die der anderen Adresse entspricht, eine aktivierte Markierung ist (S31).

5. Lese-Schreib-Verfahren nach Anspruch 2, wobei das Ausführen eines Schreibvorgangs auf einer Speichereinheit, die der Adresse entspricht, auf die der Schreibbefehl zeigt, umfasst:
Erzeugen eines zweiten ECC, der den zu schreibenden Daten im Schreibvorgang zugeordnet ist, und Schreiben des zweiten ECC zusammen mit den zu schreibenden Daten in die Speichereinheit, die der Adresse entspricht, auf die der Schreibbefehl zeigt.

6. Speicher, umfassend:
eine Befehlsempfangseinheit (40), die zum Empfangen eines Lese- oder Schreibbefehls konfiguriert ist;
eine Speichereinheit (41), die einer Adresse entspricht, die dem Lese- oder Schreibbefehl unterliegt;
eine Ausführungseinheit (43), die so konfiguriert ist, dass sie einen Lesevorgang oder einen Schreibvorgang an der Speichereinheit (41) ausführt; und
eine Markierungseinheit (42), die zum Speichern von Markierungsinformationen konfiguriert ist, wobei die Markierungsinformationen aufzeichnen, ob die Adresse aktiviert oder deaktiviert ist;
wobei die Markierungseinheit (42) eine Nachschlagetabelle ist, wobei die Nachschlagetabelle die Adresse der Speichereinheit (41) und eine anfängliche Markierung, die der Adresse entspricht, aufzeichnet, wobei die anfängliche Markierung, die der Adresse entspricht, eine aktivierte Markierung ist, und wobei als Reaktion darauf, dass ein Fehler in zu lesenden Daten auftritt, die anfängliche Markierung, die der Adresse entspricht, geändert wird, um eine deaktivierte Markierung in der Nachschlagetabelle zu sein;
und **dadurch gekennzeichnet, dass**:
die Ausführungseinheit (43) ferner mit der Markierungseinheit (42) verbunden ist, die so konfiguriert ist, dass sie auf der Grundlage der Markierungsinformationen in der Markierungseinheit (42) den Lesevorgang oder den Schreibvorgang an der Speichereinheit (41) entsprechend der Adresse ausführt oder den Lesevorgang oder den Schreibvorgang an der Speichereinheit (41) entsprechend der Adresse stoppt;
die Ausführungseinheit (43) so konfiguriert ist, dass: als Reaktion darauf, dass eine Markierung, die der Adresse entspricht, auf die der Lesebefehl zeigt, die Aktivierungsmarkierung ist, der Lesevorgang an der Speichereinheit (41), die der Adresse entspricht, auf die der Lesebefehl zeigt, ausgeführt wird; als Reaktion darauf, dass die Markierung, die der Adresse entspricht, auf die der Lesebefehl zeigt, die deaktivierte Markierung ist, bestimmt wird, ob ein Schreibbefehl an der Adresse ausgeführt wurde, auf die der Lesebefehl zeigt, nachdem die Markierung, die der Adresse entspricht, auf die der Lesebefehl zeigt, als die deaktivierte Markierung markiert ist; und als Reaktion auf das Bestimmen, dass der Schreibbefehl an der Adresse ausgeführt wurde, auf die der Lesebefehl zeigt, nachdem die Markierung, die der Adresse entspricht, auf die der Lesebefehl zeigt, als die deaktivierte Markierung markiert wurde, und der Schreibbefehl geändert wurde, um auf eine andere Adresse zu zeigen, der Lesebefehl geändert wird, um auf die andere Adresse zu zeigen, auf die der Schreibbefehl zeigt, und zu lesende Daten aus einer Speichereinheit, die der anderen Adresse entspricht, auf die der Schreibbefehl zeigt, gelesen werden; und
der Speicher ferner eine ECC-Codier-Decodier-Einheit (44) umfasst, die so konfiguriert ist, dass sie einen ersten ECC dekodiert, der den zu lesenden Daten im Lesevorgang zugeordnet ist, um zu bestimmen, ob der Fehler in den zu lesenden Daten auftritt, und einen zweiten ECC erzeugt, der den zu schreibenden Daten im Schreibvorgang zugeordnet ist.

7. Speicher nach Anspruch 6, der ferner umfasst: eine Umwandlungseinheit (45), die so konfiguriert ist, dass sie nach dem Stoppen des Lesevorgangs oder des Schreibvorgangs auf der Speichereinheit (41), die der Adresse entspricht, die Adresse, auf die der Lesebefehl oder der Schreibbefehl zeigt, auf eine andere Adresse ändert.

8. Speicher nach Anspruch 6, umfassend: eine logische Schicht (100) und mindestens eine Speicherschicht (200), wobei die Befehlsempfangseinheit (40), die Markierungseinheit (42) und die Ausführungseinheit (43) in der logischen Schicht (100) angeordnet sind und die Speichereinheit (41) in der Speicherschicht (200) angeordnet ist.

## Revendications

1. Procédé de lecture-écriture, comprenant
recevoir une commande de lecture, la commande de lecture pointant vers une adresse (S10, S20) ;
utiliser l'adresse vers laquelle pointe la commande de lecture comme index pour rechercher une marque correspondant à l'adresse vers laquelle pointe la commande de lecture dans une table de recherche (10, 20), la table de recherche (10, 20) stockant toutes les adresses d'une mémoire et les marques correspondant aux adresses, les marques comprenant des marques désactivées ou des marques activées, et une marque correspondant à une adresse non marquée comme une marque désactivée étant initialement définie comme une marque activée ; et
si la marque correspondant à l'adresse vers laquelle pointe la commande de lecture est une marque activée, lire (S11, S22) les données à lire à partir d'une unité de stockage correspondant à l'adresse vers laquelle pointe la commande de lecture ;
et **caractérisé en ce qu'**il comprend
en réponse à la marque correspondant à l'adresse vers laquelle pointe la commande de lecture étant une marque désactivée, déterminer si une commande d'écriture a été exécutée sur l'adresse vers laquelle pointe la commande de lecture après que la marque correspondant à l'adresse vers laquelle pointe la commande de lecture est marquée comme étant la marque désactivée ; et en réponse à la détermination que la commande d'écriture a été exécutée sur l'adresse vers laquelle pointe la commande de lecture après que la marque correspondant à l'adresse vers laquelle pointe la commande de lecture est marquée comme marque désactivée et que la commande d'écriture a été modifiée pour pointer vers une autre adresse, modifier la commande de lecture pour pointer vers l'autre adresse vers laquelle pointe la commande d'écriture, et lire (S22) des données à lire à partir d'une unité de stockage correspondant à l'autre adresse vers laquelle pointe la commande d'écriture ; et
en cas d'erreur se produisant dans les données à lire, marquer la marque correspondant à l'adresse vers laquelle pointe la commande de lecture comme marque désactivée ; en l'absence d'erreur se produisant dans les données à lire, conserver la marque correspondant à l'adresse vers laquelle pointe la commande de lecture, et émettre les données à lire (S24) ;
dans lequel la lecture (S11, S22) des données à lire à partir d'une unité de stockage correspondant à l'adresse vers laquelle pointe la commande de lecture comprend en outre : lire un premier code de correction d'erreur, ECC, associé aux données à lire à partir de l'unité de stockage correspondant à l'adresse vers laquelle pointe la commande de lecture ;
un procédé pour déterminer si l'erreur se produit dans les données à lire (S12, S23) comprend : le décodage du premier ECC, pour déterminer si l'erreur se produit dans les données à lire ; et
le procédé étant appliquée par la mémoire.

2. Procédé de lecture-écriture selon la revendication 1, comprenant en outre : la réception d'une commande d'écriture (S30) ; et en réponse à une marque correspondant à une adresse vers laquelle pointe la commande d'écriture étant une marque activée, l'exécution d'une opération d'écriture sur une unité de stockage correspondant à l'adresse vers laquelle pointe la commande d'écriture ; ou en réponse à la marque correspondant à l'adresse vers laquelle pointe la commande d'écriture étant une marque désactivée, l'arrêt de l'opération d'écriture sur l'unité de stockage correspondant à l'adresse vers laquelle pointe la commande d'écriture.

3. Procédé de lecture-écriture selon la revendication 2, dans lequel la réception d'une commande d'écriture (S30) comprend : l'utilisation de l'adresse vers laquelle pointe la commande d'écriture comme index, pour rechercher la marque correspondant à l'adresse vers laquelle pointe la commande d'écriture dans la table de recherche (30).

4. Procédé de lecture-écriture selon la revendication 2, dans lequel, après l'arrêt de l'opération d'écriture sur l'unité de stockage correspondant à l'adresse vers laquelle pointe la commande d'écriture, le procédé comprend en outre :
modifier l'adresse vers laquelle pointe la commande d'écriture pour la remplacer par une autre adresse ;
dans lequel, après la modification de l'adresse vers laquelle pointe la commande d'écriture en une autre adresse, le procédé comprend en outre déterminer si une marque correspondant à l'autre adresse est une marque activée (S31).

5. Procédé de lecture-écriture selon la revendication 2, dans lequel l'exécution d'une opération d'écriture sur une unité de stockage correspondant à l'adresse vers laquelle pointe la commande d'écriture comprend :
générer une deuxième ECC associée aux données à écrire dans l'opération d'écriture, et écrire la deuxième ECC avec les données à écrire dans l'unité de stockage correspondant à l'adresse vers laquelle pointe la commande d'écriture.

6. Mémoire, comprenant
une unité de réception de commande (40), configurée pour recevoir une commande de lecture ou une commande d'écriture ;
une unité de stockage (41), correspondant à une adresse soumise à la commande de lecture ou à la commande d'écriture ;
une unité d'exécution (43), configurée pour exécuter une opération de lecture ou d'écriture sur l'unité de stockage (41) ; et
une unité de marquage (42), configurée pour stocker des informations de marquage, les informations de marquage indiquant si l'adresse est activée ou désactivée ;
dans laquelle l'unité de marquage (42) est une table de recherche, la table de recherche enregistrant l'adresse de l'unité de stockage (41) et une marque initiale correspondant à l'adresse, la marque initiale correspondant à l'adresse étant une marque activée, et en réponse à une erreur se produisant dans les données à lire, la marque initiale correspondant à l'adresse étant modifiée pour devenir une marque désactivée dans la table de recherche ;
et **caractérisée en ce que** :
l'unité d'exécution (43) est en outre connectée à l'unité de marquage (42), configurée pour, sur la base des informations de marquage dans l'unité de marquage (42), exécuter l'opération de lecture ou l'opération d'écriture sur l'unité de stockage (41) correspondant à l'adresse, ou arrêter l'opération de lecture ou l'opération d'écriture sur l'unité de stockage (41) correspondant à l'adresse ;
l'unité d'exécution (43) est configurée pour : en réponse à une marque correspondant à l'adresse vers laquelle pointe la commande de lecture étant la marque activée, exécuter l'opération de lecture sur l'unité de stockage (41) correspondant à l'adresse vers laquelle pointe la commande de lecture ; en réponse à la marque correspondant à l'adresse vers laquelle pointe la commande de lecture étant la marque désactivée, déterminer si une commande d'écriture a été exécutée sur l'adresse vers laquelle pointe la commande de lecture après que la marque correspondant à l'adresse vers laquelle pointe la commande de lecture est marquée comme étant la marque désactivée ; et en réponse à la détermination que la commande d'écriture a été exécutée sur l'adresse vers laquelle pointe la commande de lecture après que la marque correspondant à l'adresse vers laquelle pointe la commande de lecture est marquée comme la marque désactivée et que la commande d'écriture a été modifiée pour pointer vers une autre adresse, modifier la commande de lecture pour pointer vers l'autre adresse vers laquelle pointe la commande d'écriture, et lire les données à lire à partir d'une unité de stockage correspondant à l'autre adresse vers laquelle pointe la commande d'écriture ; et
la mémoire comprend en outre une unité de codage-décodage ECC (44), configurée pour décoder une première ECC associée aux données à lire dans l'opération de lecture afin de déterminer si l'erreur se produit dans les données à lire, et pour générer une deuxième ECC associée aux données à écrire dans l'opération d'écriture.

7. Mémoire selon la revendication 6, comprenant en outre : une unité de conversion (45), configurée pour, après avoir arrêté l'opération de lecture ou l'opération d'écriture sur l'unité de stockage (41) correspondant à l'adresse, modifier l'adresse vers laquelle pointe la commande de lecture ou la commande d'écriture en une autre adresse.

8. Mémoire selon la revendication 6, comprenant : une couche logique (100) et au moins une couche de stockage (200), l'unité de réception de commande (40), l'unité de marquage (42) et l'unité d'exécution (43) étant disposées dans la couche logique (100), et l'unité de stockage (41) étant disposée dans la couche de stockage (200).
